# EUROPEAN PATENT SPECIFICATION

(11) **EP 1 990 441 B1**
(45) Date of publication and mention of the grant of the patent: **04.01.2012**
(21) Application number: 07704761.1
(22) Date of filing: 31.01.2007
(51) Int. Cl.: C23C 14/02, C23C 14/34

(54) **METHOD AND APPARATUS FOR REGISTERING DIFFRACTIVE OPTICAL STRUCTURES**
VERFAHREN UND VORRICHTUNG ZUR REGISTRIERUNG VON DIFFRAKTIVEN OPTISCHEN STRUKTUREN
PROCÉDÉ ET APPAREIL POUR LE REGISTRE DE STRUCTURES OPTIQUES DIFFRACTIVES

(30) Priority: 24.02.2006 ES 200600446
(43) Date of publication of application: 12.11.2008
(73) Proprietor: Universidad de Cádiz, 11001, Cádiz (ES)
(72) Inventor: GONZÁLEZ LEAL, Juan, Maria, E-11510 Puerto Real (Cádiz) (ES); ÁNGEL RUIZ, José Andrés, E-11510 Puerto Real (Cádiz) (ES)
(74) Representative: ABG Patentes, S.L.
(86) International application number: PCT/ES2007/000052
(87) International publication number: WO 2007/096440

(56) References cited:
- WO-A1-00/44960
- GB-A- 2 300 001
- JP-A- 04 045 263
- US-A- 4 701 592
- US-A- 5 760 366
- US-A- 5 952 271
- US-A1- 2004 031 778
- ZIMMER ET AL: "Precise etching of fused silica for refractive and diffractive micro-optical applications" OPTICS AND LASERS IN ENGINEERING, ELSEVIER LNKD- DOI:10.1016/J.OPTLASENG.2004.12.003, vol. 43, no. 12, 1 December 2005 (2005-12-01), pages 1349-1360, XP005004019 ISSN: 0143-8166

## Description

### REFERENCES CITED

### PATENTS

| | | |
|---|---|---|
| US 5910256 | 6/1999 | Tsunetomo et al. |
| US 6110291 | 8/2000 | Haruta et al. |
| US 6452698 B1 | 9/2002 | Vlcek et al. |
| US 6649861 B2 | 11/2003 | Duignan |
| US 6766764 B1 | 7/2004 | Chrisey et al. |
| US 6924457 B2 | 8/2005 | Koyama et al. |

### OTHER PUBLICATIONS

J. Teteris and M. Reinfelde, "Holographic recording in amorphous chalcogenide semiconductor thin films", Journal of Non-Crystalline Solids 326&327 (2003) 494.

A.V. Kolobov and Ka. Tanaka, in "Photoinduced Phenomena in Amorphous Chalcogenides: From Phenomenology to Nanoscale", Handbook of Advanced Electronic and Photonic Materials and Devices, Vol. 5, Hari Singh Nalwa, ed. (Academic Press, San Diego, 2001), p. 47.

A. Zakery, Y. Ruan, A. V. Rode, M. Samoc and B. Luther-Davies, "Low-loss waveguides in ultrafast laser-deposited As2S3 chalcogenide films", J. Opt. Soc. Am. B 20 (2003) 1844.

### FIELD OF THE INVENTION

The present invention lies within the field of optical elements with diffractive functions, and methods of manufacturing them.

### PRIOR ART

Optical elements are very important in all technological fields where it is necessary to modulate the spatial distribution of light. Bearing in mind this requirement, it is necessary to optimise techniques of manufacturing simple optical structures and producing optical structures with new functions.

There are a variety of methods for manufacturing diffractive optical elements, and for recording diffractive structures on semiconductor media, which are based on processing a support material using classical photolithographic techniques, or other more modern techniques of laser ablation [US 5910256] [US 6924457 B2] or holographic recording [US 6452698 B1] [Teteris and Reinfelde]. Unlike the present invention, all of them share the sequential (non-concurrent) nature of the process, i.e. the methods include (a) the prior preparation of the support material, and (b) its subsequent processing.

Furthermore, due to their relevance to the invention disclosed and claimed herein, to the applicants' understanding it is important to mention light-assisted deposition methods, which are widely known and used in planar technologies [US 6110291]. In these technologies pulsed lasers are used to deposit conductor, semiconductor and superconductor compounds, which are used in active and passive optical and/or electronic devices. Thus, there are patents claiming rights over the industrial use of a variety of planar devices based on the pulsed laser deposition or PLD method. An advanced search also shows that in all the cases the inventions avoid the interaction between the laser beam and the vapour phase, or plasma plume, generated from the starting material, so that the configuration of the systems that are used involve the pulsed beam that brings about the ablation of the starting material and the plume of the ejected material being non-collinear, and in no case do they involve any concurrent action on the deposit using light irradiation during its growth.

Moreover, due to its relevance to the present invention, and in order to demonstrate its inventive activity, we cite the only case found [US 6766764 B1] wherein a pulsed laser beam falls on one side of a transparent substrate. In this patent, rather than the transparent substrate being designed to act as a support for the deposit and to enable it to be structurally photomoulded during its growth, it is designed to support the starting material. The cited invention involves the substrate supporting a layer of a material that is photoevaporable, which in turn supports a layer of material to be deposited on a second substrate. The basis of this invention is that the photoinduced evaporation of the transfer material, through the transparent substrate, brings about the ejection of the material of interest in a localised area of the recipient substrate. As in the previous cases, this invention does not involve any concurrent action on the deposit using light irradiation during its growth.

Finally, we highlight, once again as far as our search has taken us, that the only case found that contemplates the structuring of the deposit is carried out sequentially, in two steps, in the manufacturing system, producing a prior planar deposit, by means of light irradiation, and subsequently ablating it, also by light irradiation, which is subject to a change in the configuration of the system that enables the exposure of the material that has already been deposited to the light beam [US 6649861 B2]. In any case, the object of the invention (planar technologies) is not relevant to the inventive activity disclosed herein.

### BASIS OF THE INVENTION

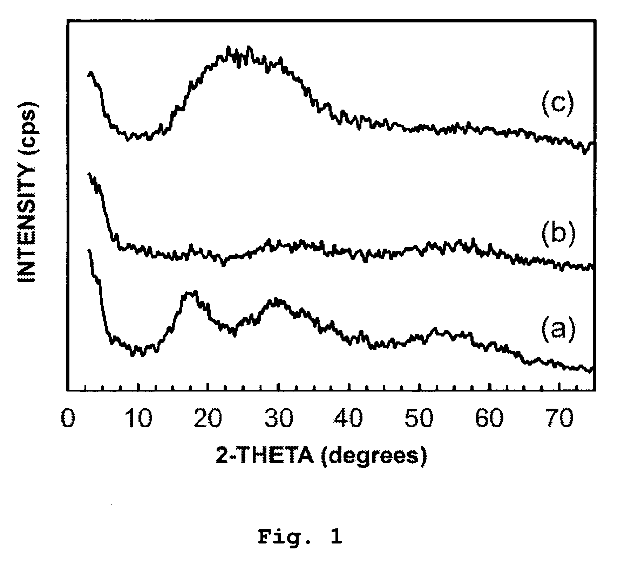

The present invention proposes a light-assisted method of manufacturing deposits of semiconductor compounds that act as a support for diffractive optical structures, which is based on the following physical facts:
1. Structural fragments of the constituent elements of semiconductor compounds can be ejected from a solid when they are irradiated with light whose photon energy is comparable (in the order of magnitude) to its optical gap, with a high enough intensity. This intensity depends on the type of semiconductor material.
2. The vapour phase, or plasma plume, that is generated condenses on a substrate located in the proximity of the starting material, causing this material to be deposited on the substrate.
3. The morphology of the deposit is related to the characteristics of the plume or vapour phase, which depend on the spatial light intensity distribution on the target material, the spectral radiance of the light source, the distance between the target material and the substrate, the pressure and the atmosphere in the chamber, the temperature of the starting material, the temperature of the substrate, and the irradiation time.
4. Concurrent illumination of the deposit during its growth affects the physicochemical properties of the material that forms said deposit as a consequence of its effect on the structure of the material being formed (see
Figure 1). The creation of structures with a diffractive function may be controlled through the spatial light intensity distribution that concurrently falls on the deposit area of the substrate, and they may cover a large interval of diffractive gaps [Kolobov and Tanaka]. These may be phase structures (consequence of local changes in the thickness and/or the refractive index on the deposit) and/or amplitude structures (consequence of local changes in the absorption coefficient on the deposit).

On the basis of the aforementioned facts, the applicants of the present patent propose a simple but not obvious method of manufacturing diffractive optical structures on semiconductor media.

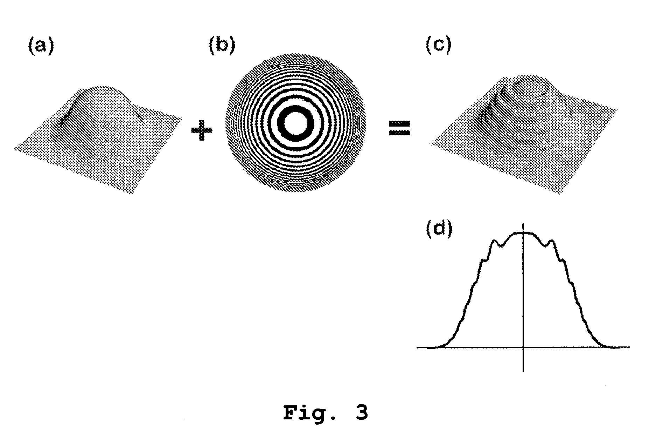

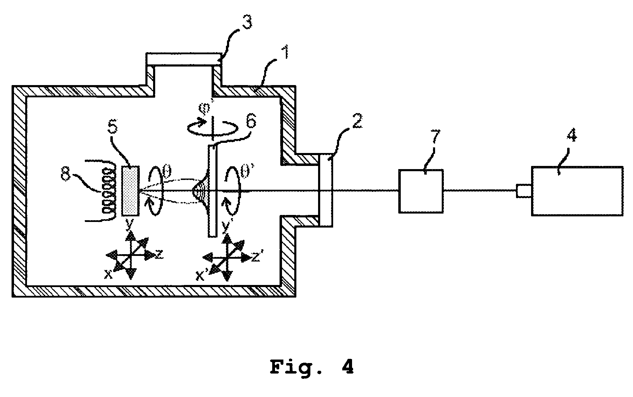

In a preferred embodiment of the invention, which is not limiting in terms of the material used or the configuration of the manufacturing system, a continuous laser beam, with a wavelength of 532 nm and a spatial light intensity distribution with its phase following a pattern of Fresnel zones, perpendicularly crosses a transparent substrate with planoparallel sides before reaching a target material situated a few millimetres from the substrate. Said modulation may be achieved with a set of optical elements as shown in Figure 3. This combination serves as an example of items 7, 10, 13 and 16, which are shown in Figures 4, 5, 6 and 7. Said target material is a disc (wafer) with a diameter of around 1 cm and a thickness of 2 mm, made from compacted powder of an amorphous V-VI semiconductor alloy (e.g. an alloy of As and S), which is sensitive to the photon energy of light radiation from a Nd:YAG laser (2.33 eV). The sides of the substrate and the wafer that face each other are parallel.

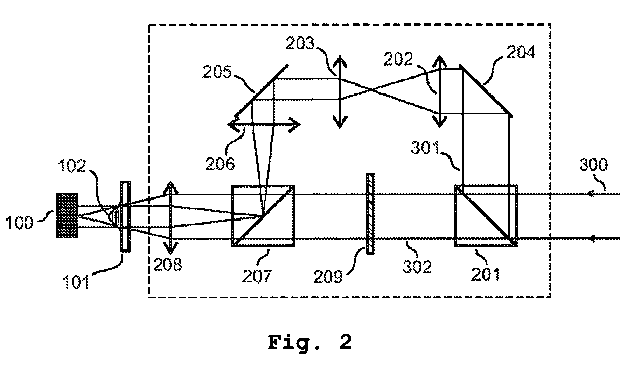

The above-described configuration produces a deposit with an aspheric morphology, which supports a distribution of concentric rings in the form of surface reliefs of high spatial frequency, as shown in Figure 2. Said optical elements combine the refractive function of the profile of low spatial frequency with the added diffractive function of high spatial frequency using Fresnel zones. This combination may be used to compensate e.g. chromatic aberrations that these optical structures present when they perform their characteristic optical function independently.

The transparency of V-VI semiconductors in the infrared (IR) spectral region [Kolobov and Tanaka] guarantees the stability of the optical elements manufactured in this spectral window, therefore making it the preferred working spectral region.

However, the applicants of the present patent have observed that the optical elements produced according to the above-described preferred embodiment present a greater optical transparency and a higher damage threshold to the laser radiation used in the manufacturing process compared to that of the starting material, possibly due to concurrent illumination of the material being deposited. In experiments, an increase of more than one order of magnitude has been observed in the damage intensity in alloys with a composition of As₂₀S₈₀, in relation to the intensity supported by the starting material.

Furthermore, due to its relevance to the present invention, it has been shown [Zakery et al.] that coating an amorphous chalcogenide deposit with a layer of polymethyl methacrylate (PMMA) increases by several orders of magnitude the damage threshold to radiation for which the chalcogenide alloy would be sensitive without any coating.

In view of such facts, both of our own and reported in the literature, it can be inferred that although the IR region is the preferred window, it should not be considered the only one.

### DESCRIPTION OF THE FIGURES

- FIGURE 1.: X-ray diffraction patterns corresponding to: (a) an ingot of the amorphous alloy As₂₀S₈₀, (b) a wafer made from the compacted powder of this material, which constitutes the starting material used in the real examples described in this patent, and (c) a deposit of this starting material carried out using the method disclosed herein. The results show the structural difference between the deposited material and the starting material.
- FIGURE 2.: Diagram showing the combination of the refractive function of an aspheric optical element (a) and the diffractive function of an optical element consisting of Fresnel zone plates (b), to form an optical element as shown in (c), with the cross section shown in (d).
- FIGURE 3.: Example of a combination of optical elements that produces a modulation in the light intensity in the form of Fresnel zone plates. Said radiation acts on the deposit being formed, to manufacture, according to the present invention, an optical element that combines refractive and diffractive functions.
Items:
100.- Starting material.
101.- Substrate.
102.- Deposit.
201.- Beam splitter.
202.- Lens.
203.- Lens.
204.- Mirror.
205.- Mirror.
206.- Lens.
207.- Beam splitter.
208.- Lens.
209.- Attenuator.
300.- Light beam.
301.- Transversal component of the beam 300 after passing through the beam splitter 201.
302.- Longitudinal component of the beam 300 after passing through the beam splitter 201.
- FIGURE 4: Cross-sectional diagram of the system for producing optical elements with a diffractive function according to the present invention, in a collinear configuration, wherein a single light beam generates the vapour phase of the starting material and concurrently irradiates the deposit during its growth. Items:
1.- Chamber.
2 and 3.- Transparent windows in the chamber.
4.- Source of light radiation.
5.- Starting material.
6.- Substrate.
7.- Combination of optical and/or mechanical elements.
8.- Heater.
- FIGURE 5.: Cross-sectional diagram of the system for producing optical elements with a diffractive function according to the present invention, in a collinear configuration, wherein more than one source of light radiation is involved in the process. Items:
1.- Chamber.
2 and 3.- Transparent windows in the chamber.
4.- Source of light radiation.
5.- Starting material.
6.- Substrate.
7.- Combination of optical and/or mechanical elements.
8.- Heater.
9.- Source of light radiation.
10.- Combination of optical and/or mechanical elements.
11.- Beam splitter.

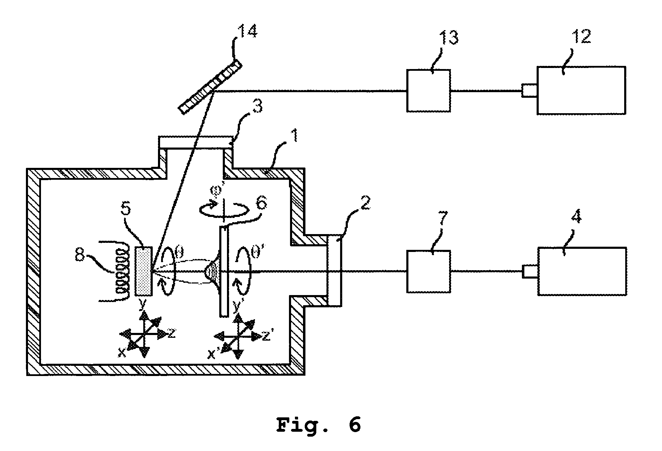

- FIGURE 6.: Cross-sectional diagram of the system for producing optical elements with a diffractive function according to the present invention, in a non-collinear configuration, wherein only one source of light radiation is involved in the ejection of the starting material, and an additional source of radiation is involved in creating diffractive structures on the deposit. Items:
1.- Chamber.
2 and 3.- Transparent windows in the chamber.
4.- Source of light radiation.
5.- Starting material.
6.- Substrate.
7.- Combination of optical and/or mechanical elements.
8.- Heater.
12.- Source of light radiation.
13.- Combination of optical and/or mechanical elements.
14.- Mirror.

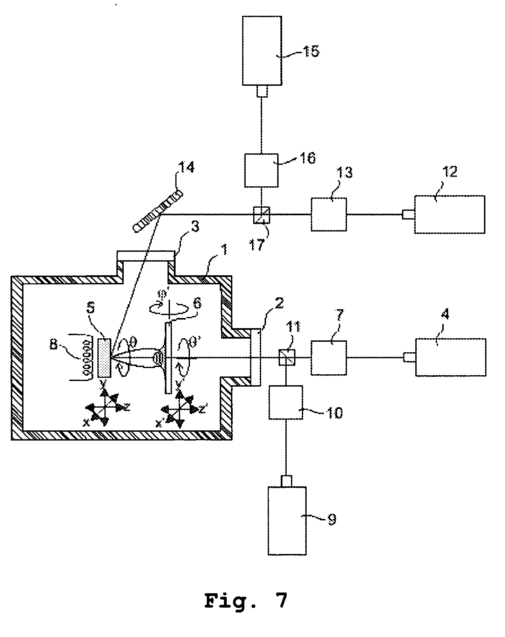

- FIGURE 7.: Cross-sectional diagram of the system for producing optical elements with a diffractive function according to the present invention, in a non-collinear configuration, wherein two or more sources of light radiation are involved in the ejection of the starting material, and two or more additional sources of radiation are involved in creating diffractive structures on the deposit. Items:
1.- Chamber.
2 and 3.- Transparent windows in the chamber.
4.- Source of light radiation.
5.- Starting material.
6.- Substrate.
7.- Combination of optical and/or mechanical elements.
8.- Heater.
9.- Source of light radiation.
10.- Combination of optical and/or mechanical elements.
11.- Beam splitter.
12.- Source of light radiation.
13.- Combination of optical and/or mechanical elements.
14.- Mirror.
15.- Source of light radiation.
16.- Combination of optical and/or mechanical elements.
17.- Beam splitter.

### DESCRIPTION OF THE INVENTION

The present invention proposes a method for manufacturing diffractive optical elements in a simple and economical way. This method includes the following steps: (a) situating a transparent substrate close to a target material, both of which are situated inside a chamber, (b) bringing about the vaporisation or sublimation of the target material, (c) depositing this vapour phase on the substrate, and (d) concurrently irradiating the area of the substrate where the deposit occurs with an arbitrary light intensity distribution. The deposit presents a diffractive optical function due to the local changes induced in its structure, governed by the light intensity distribution used in the manufacturing process.

The objects of the present invention are as follows:
- to provide a simple method of manufacturing optical elements with diffractive function,
- to provide a method of manufacturing diffractive optical elements using light radiation,
- to provide a method for manufacturing optical elements that combine refractive and diffractive functions,
- to provide a method of manufacturing diffractive optical elements with extended functions at high light intensities,
- to provide a method for improving the stability and prolonging the life of optical structures with a diffractive function that are created on semiconductor media.

Figure 4 shows a first preferred embodiment according to the proposed method for manufacturing optical elements that combine refractive and diffractive functions. With reference to this figure, the system consists of a chamber 1 with transparent windows 2 and 3, and a source of continuous or pulsed light radiation 4, a starting material 5, and a substrate 6 which is transparent to the radiation from 4, and also transparent to the working radiation for which the optical element to be manufactured is designed. The spatial light intensity distribution on the deposit is controlled by 7, which is a combination of optical (lenses, mirrors, filters, beam splitters, masks, spatial light, phase and amplitude modulators, etc.) and/or mechanical (linear positioning stages, angular positioning stages, mechanical spatial light modulators, etc.) elements.

The method contemplates the possibility of several beams emerging from 7 and falling on the area of the substrate where the material will be deposited, to record e.g. a Bragg grating, controlling the spacing of the grating by controlling the angle between the interfering beams. The light beam from 4 (or beams, bearing in mind the above) enters the chamber through the window 2, and crosses the substrate 6 before falling on the starting material 5, bringing about its ejection. The generation of this plume can be assisted by heat from a heater 8. The deposition can also be thermally assisted by supplying heat to the substrate, in a similar way to 8 (not shown in Figure 4). The deposition is carried out at a controlled pressure and atmosphere.

The starting material 5, which is situated inside the chamber, can be an ingot of a semiconductor alloy, or a wafer made from the alloy to be deposited in powder form. The wafer can be a heterogeneous mixture of semiconductor alloys and other reactants, which act as both passive and active elements for a determined light radiation. The starting material is supported by a combination of mechanical elements that give it freedom to move in the three Cartesian directions, x, y, z, and to rotate around an axis that is perpendicular to its surface, θ.

The substrate 6 is supported by a combination of mechanical elements. The substrate is thus free to move in the three Cartesian directions, x', y', z', as well as to rotate around an axis that is perpendicular to its surface, θ', and around an axis that is parallel to its surface, ϕ', in a way that is not integral to the starting material.

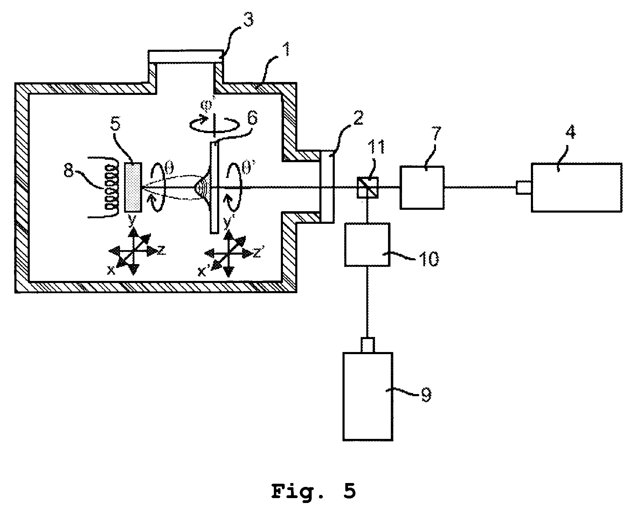

Figure 5 shows a second preferred embodiment according to the proposed method for manufacturing optical elements that combine refractive and diffractive functions. With reference to this figure, and similarly to that described for Figure 4, the system consists of a chamber 1 with transparent windows 2 and 3, and a source of continuous or pulsed light radiation 4, a second source of continuous or pulsed light radiation 9, a starting material 5, and a substrate 6 that is transparent to the radiation from 4 and 9, and also transparent to the working radiation for which the optical element to be manufactured is designed. The spatial light intensity distribution of the radiations from 4 and 9 is controlled by combinations of optical (lenses, mirrors, filters, beam splitters, masks, spatial light, phase and amplitude modulators, etc.) and/or mechanical (linear positioning stages, angular positioning stages, mechanical spatial light modulators, etc.) elements 7 and 10, respectively. As in the aforementioned embodiment, the method contemplates the possibility of several light beams emerging from 7 and 10. The beams from sources 4 and 9 are directed into the chamber through the window 2 via the beam splitter 11, with either coinciding or non-coinciding directions of propagation. Both light beams from sources 4 and 9 cross the substrate 6, and at least one of them brings about the ejection of the starting material 5. The generation of the plume may be assisted by heat using a heater 8. The deposition may also be thermally assisted by supplying heat to the substrate in a similar way to 8 (not shown in Figure 5). The deposition is carried out at a controlled pressure and atmosphere.

Figure 6 shows a third preferred embodiment according to the proposed method for manufacturing optical elements that combine refractive and diffractive functions. With reference to this figure, and similarly to that described for Figures 4 and 5, the system consists of a chamber 1 with transparent windows 2 and 3, and a continuous or pulsed source of light radiation 4, a second source of continuous or pulsed light radiation 12, a starting material 5, and a substrate 6 that is transparent to the radiation from 4, and also transparent to the working radiation for which the optical element to be manufactured is designed. The spatial light intensity distribution of the radiations from 4 and 12 is controlled by combinations of optical (lenses, mirrors, filters, beam splitters, masks, spatial light, phase and amplitude modulators, etc.) and/or mechanical (linear positioning stages, angular positioning stages, mechanical spatial light modulators, etc.) elements 7 and 13, respectively.

The beam from source 4 enters the chamber through the window 2, and crosses the substrate 6 to irradiate the material that is to be deposited. The beam from source 12 enters the chamber through the window 3, via the mirror 14, and falls on the starting material, bringing about its ejection. The generation of the plume can be assisted by heat from a heater 8. The deposition can also be thermally assisted by supplying heat to the substrate, in a similar way to 8 (not shown in Figure 6). The deposition is carried out at a controlled pressure and atmosphere.

Figure 7 shows a fourth preferred embodiment according to the proposed method, which is more general, for manufacturing optical elements that combine refractive and diffractive functions. With reference to this figure, and similarly to that described for Figures 4, 5 and 6, the system consists of a chamber 1 with transparent windows 2 and 3, a pair of sources of continuous or pulsed light radiation 4 and 9, which are responsible for recording diffractive structures, a second pair of sources of continuous or pulsed light radiation 12 and 15, which are responsible for bringing about the ejection of the starting material 5, and a substrate 6 that is transparent to the radiation from 4 and 9, and also transparent to the working radiation for which the optical element to be manufactured is designed. The spatial light intensity distribution of the radiations from 4, 7, 12 and 15 is controlled by combinations of optical (lenses, mirrors, filters, beam splitters, masks, spatial light, phase and amplitude modulators, etc.) and/or mechanical (linear positioning stages, angular positioning stages, mechanical spatial light modulators, etc.) elements 7, 10, 13 and 16, respectively. The beams from sources 4 and 9 are directed into the chamber through the window 2 via the beam splitter 11, with either coinciding or non-coinciding directions of propagation. The beams from sources 12 and 15 are combined by the beam splitter 17 and enter the chamber through the window 3, via the mirror 14, falling on the starting material and bringing about its ejection. The generation of the plume can be assisted by heat from a heater 8. The deposition can also be thermally assisted by supplying heat to the substrate, in a similar way to 8 (not shown in Figure 7). The deposition is carried out at a controlled pressure and atmosphere.

A real embodiment is described below to illustrate the use of the present invention for manufacturing an aspheric lens that combines refractive and diffractive functions, which is highly transparent in the IR region, with a high damage threshold. The starting material 100, in this case, is a circular wafer with a 13 mm diameter, made from 125 mg of powder, compacted for 10 minutes with a 10-tonne load, of an amorphous chalcogenide alloy with a composition of As₂₀S₈₀, which presents an optical gap of 2.1 eV. The pressure in the chamber is reduced to below 10-4 mbar. The light radiation 300 comes from a Nd:YAG continuous laser generator emitting at 532 nm (2.33 eV), with a power of 1.5 W. The beam is treated according to the optical assembly shown in Figure 3. The beam is filtered using a spatial filter, and collimated with a lens that has a focal length of 150 mm (not shown in Figure 3). The beam is split using a beam splitter cube (201). The section of one of the emerging beams (301) is reduced using a combination of a lens with a focal length of 150 mm (202) and another one with a focal length of 75 mm (203), and mirrors (204 and 205) are used to direct it. This beam is focused by means of a lens (206) with a focal length of 50 mm, and it is directed at a second beam splitter (207). The transversal component that results from the interaction of the beam 301 with the beam splitter cube 207 is collimated by means of a lens (208) with a focal length of 50 mm. This lens constitutes the outlet of the optical assembly before the resulting radiation enters the chamber. Meanwhile, the second beam emerging from the first beam splitter (302) passes through an attenuator (209) to compensate for the losses suffered by 301. The beam 302 crosses the second beam splitter (207) and is focused by the lens (208) with a 50 mm focal length that faces the chamber. The beam 302 mainly induces the ejection of the starting material. The material ejected from the surface of the wafer generates a distribution of the vapour phase in the form of a spindle (plume), which is perpendicular to the irradiated surface of the wafer. The transparent substrate (101) is situated in the chamber perpendicular to the optical axis of the above-described assembly, at 2 mm from the starting material, and it is passed through by the radiation generated at the outlet of said assembly. The vapour phase of this material (102) condenses on the side of the substrate that faces the starting material, presenting an aspheric spatial distribution on its surface. The concurrent action of the light radiation, which is modulated according to the pattern generated by the beams 301 and 302 falling on the deposit, produces a surface relief on the aspheric surface in the form of Fresnel zone plates. It cannot be ruled out that, as well as producing the surface relief that is observed, the light radiation brings about localised changes in the refractive index and/or the absorption coefficient in the deposited material. If it were not affected by the refractive profile, the diffractive structure created according to the above-described embodiment would act as a phase diffractive lens with a focal length of approximately 25 mm.

The conditions of the system may be adjusted to deposit a uniform profile or a profile of a variable thickness, concentrated on a localised region of the substrate or extended across it arbitrarily. The area covered by the deposit and the thickness profiles may be controlled by moving the light beam over the surface of the starting material and/or the substrate by means of the positioning stages that give the starting material and the substrate the degrees of freedom x, y, z, θ, x', y', z', θ', ϕ', respectively, which are shown in the diagrams in Figures 4, 5, 6 and 7.

## Claims

1. Method for manufacturing diffractive optical elements **characterised in that** it comprises the following operative stages:
(a) situating a substrate (6), which is transparent to both the working radiation for which the optical element being manufactured is designed and the radiation used in the manufacturing process, close to a starting material (5), both of which are situated inside a chamber (1);
(b) spatially modulating a radiation from at least a source of light radiation (4) according to a required pattern of diffraction;
(c) irradiating the substrate (6) so that the radiation crosses it;
(d) exposing the starting material (5) to the radiation transmitted through the substrate (6), so that as the radiation falls on the starting material (5) its evaporation or sublimation occurs;
(e) depositing the vapour phase of the starting material (5) on the substrate (6);
(f) recording a diffractive structure on the deposited material during the deposition process, concurrently irradiating the deposited material through the substrate (6) with the modulated radiation.

2. Method for manufacturing diffractive optical elements according to claim 1, **characterised in that** the light radiations involved in the process are continuous or pulsed.

3. Method for manufacturing diffractive optical elements according to claims 1 to 2, **characterised in that** the light radiations involved in the process are monochromatic or polychromatic.

4. Method for manufacturing diffractive optical elements according to claims 1 to 3, **characterised in that** the light radiations involved in the process are coherent or incoherent.

5. Method for manufacturing diffractive optical elements according to claims 1 to 4, **characterised in that** the starting material (5) is an ingot or a wafer made from the pressed powder of the material to be deposited.

6. Method for manufacturing diffractive optical elements according to claims 1 to 5, **characterised in that** the starting material (5) can be a homogeneous or heterogeneous mixture of semiconductor alloys containing a chalcogen element (O, S, Se and/or Te) and other reactants, which act as both passive and active elements for a determined light radiation.

7. Method for manufacturing diffractive optical elements according to claims 1 to 6, **characterised in that** the process is carried out with a controlled pressure and atmosphere.

8. Method for manufacturing diffractive optical elements according to claims 1 to 7, **characterised in that** the vapour or plasma phase present in the process results from the evaporation and/or sublimation of the starting material (5) by means of the joint action of heating and light radiation.

9. Method for manufacturing diffractive optical elements according to claims 1 to 8, **characterised in that** the temperature of the substrate (6) is different to room temperature.

10. Method for manufacturing diffractive optical elements according to any of claims 1 to 9, **characterised in that** the sides of the starting material (5) and the substrate (6) that face each other are parallel.

11. Apparatus for manufacturing diffractive optical elements, which comprises:
(a) a chamber (1) with at least one transparent window,
(b) a vacuum system,
(c) a source of light radiation,
(d) a substrate (6) that is transparent to both the working radiation for which the optical element to be manufactured is designed and radiation from the source of light radiation, said substrate (6) being situated in the optical path of the radiation from the source of light radiation,
(e) a mechanical means of support, situated inside the chamber (1), which supports the substrate (6) and gives it the freedom to move in the three Cartesian directions, x', y', z', as well as to rotate around an axis that is perpendicular to its surface, θ', and around an axis that is parallel to its surface, ϕ',
(f) a starting material (5), situated in the optical path of the radiation transmitted through the substrate (6) and situated sufficiently close to the substrate (6) so that the vapour phase generated by the irradiation condenses on the substrate (6),
(g) a mechanical means of support, situated inside the chamber (1), which supports the starting material (5) and gives it the freedom to move in the three Cartesian directions, x, y, z, as well as to rotate around an axis that is perpendicular to its surface, θ, so that it is not integral to the substrate (6),
(h) an opto-mechanical means of modulation (7, 10), situated outside the chamber (1), which modulates the spatial distribution of the light radiation that falls on the substrate (6) according to the required diffractive pattern.

12. Apparatus for manufacturing diffractive optical elements, according to claim 11, **characterised in that** it has a system for injecting gases.

13. Apparatus for manufacturing diffractive optical elements, according to claim 11, **characterised in that** it has a heat source for the starting material (5).

14. Apparatus for manufacturing diffractive optical elements, according to claim 11, **characterised in that** it has a heat source for the substrate (6).

15. Apparatus for manufacturing diffractive optical elements, according to claims 11 to 14, **characterised in that** it has additional sources of light radiation to bring about the ejection of the starting material (5).

16. Apparatus for manufacturing diffractive optical elements, according to claims 11, to 14, **characterised in that** it has additional sources of light radiation to record diffractive structures.

17. Apparatus for manufacturing diffractive optical elements according to claims 15, or 16, **characterised in that** the light radiations present in the process are the same in terms of their coherence, chromaticity and time regime (pulsed or continuous).

18. Apparatus for manufacturing diffractive optical elements according to claims 15 or 16, **characterised in that** the light radiations present in the process are different in terms of their direction of propagation, intensity, coherence, chromaticity and time regime (pulsed or continuous).

## Patentansprüche

1. Verfahren zur Herstellung optischer Beugeelemente, **gekennzeichnet dadurch, dass** es die folgenden Betriebsvorgänge umfasst:
(a) Anordnen eines Substrats (6), das sowohl für die Arbeitsstrahlung, für die das herzustellende optische Element ausgelegt ist, als auch für die beim Herstellungsprozess verwendete Strahlung transparent ist, nahe einem Ausgangsmaterial (5), wobei beide innerhalb einer Kammer (1) angeordnet sind;
(b) räumliches Modulieren einer Strahlung von mindestens einer Lichtstrahlungsquelle (4) gemäß einem erforderlichen Beugungsmuster;
(c) Bestrahlen des Substrats (6), so dass die Strahlung es kreuzt;
(d) Aussetzen des Ausgangsmaterials (5) der Strahlung, die durch das Substrat (6) hindurch übertragen wird, so dass, wenn die Strahlung auf das Ausgangsmaterial (5) trifft, dessen Verdunstung oder Sublimation eintritt;
(e) Ablagern der Dampfphase des Ausgangsmaterials (5) auf dem Substrat (6);
(f) Aufzeichnen einer Beugungsstruktur auf dem abgelagerten Material während des Ablagerungsprozesses, während gleichzeitig das abgelagerte Material durch das Substrat (6) hindurch mit der modulierten Strahlung bestrahlt wird.

2. Verfahren zur Herstellung optischer Beugeelemente nach Anspruch 1, **gekennzeichnet dadurch, dass** die im Prozess vorkommenden Lichtstrahlungen kontinuierlich oder pulsierend sind.

3. Verfahren zur Herstellung optischer Beugeelemente nach Anspruch 1 bis 2, **gekennzeichnet dadurch, dass** die im Prozess vorkommenden Lichtstrahlungen monochromatisch oder polychromatisch sind.

4. Verfahren zur Herstellung optischer Beugeelemente nach einem der Ansprüche 1 bis 3, **gekennzeichnet dadurch, dass** die im Prozess vorkommenden Lichtstrahlungen kohärent oder inkohärent sind.

5. Verfahren zur Herstellung optischer Beugeelemente nach einem der Ansprüche 1 bis 4, **gekennzeichnet dadurch, dass** das Ausgangsmaterial (5) ein Rohblock oder ein Wafer ist, der aus dem gepressten Pulver des abzulagernden Materials hergestellt ist.

6. Verfahren zur Herstellung optischer Beugeelemente nach einem der Ansprüche 1 bis 5, **gekennzeichnet dadurch, dass** das Ausgangsmaterial (5) ein homogenes oder heterogenes Gemisch aus Halbleiterlegierungen sein kann, die ein Chalkogen-Element (O, S, Se und/oder Te) und andere Reaktionsmittel enthalten, die sowohl als passive als auch als aktive Elemente für eine bestimmte Lichtstrahlung wirken.

7. Verfahren zur Herstellung optischer Beugeelemente nach einem der Ansprüche 1 bis 6, **gekennzeichnet dadurch, dass** der Prozess mit gesteuertem Druck und Umgebung ausgeführt wird.

8. Verfahren zur Herstellung optischer Beugeelemente nach einem der Ansprüche 1 bis 7, **gekennzeichnet dadurch, dass** die im Prozess vorhandene Dampf- oder Plasmaphase aus der Verdunstung und/oder Sublimation des Ausgangsmaterials (5) mittels der gemeinsamen Wirkung von Erwärmung und Lichtstrahlung resultiert.

9. Verfahren zur Herstellung optischer Beugeelemente nach einem der Ansprüche 1 bis 8, **gekennzeichnet dadurch, dass** die Temperatur des Substrats (6) von der Raumtemperatur verschieden ist.

10. Verfahren zur Herstellung optischer Beugeelemente nach einem der Ansprüche 1 bis 9, **gekennzeichnet dadurch, dass** die einander gegenüberliegenden Seiten des Ausgangsmaterials (5) und des Substrats (6) zueinander parallel sind.

11. Vorrichtung zur Herstellung optischer Beugeelemente, die umfasst:
(a) eine Kammer (1) mit mindestens einem transparenten Fenster,
(b) ein Vakuumsystem,
(c) eine Lichtstrahlungsquelle,
(d) ein Substrat (6), das sowohl für die Arbeitsstrahlung, für die das herzustellende optische Element ausgelegt ist, als auch für die Strahlung aus der Lichtstrahlungsquelle transparent ist, wobei das Substrat (6) im optischen Pfad der Strahlung aus der Lichtstrahlungsquelle angeordnet ist,
(e) eine mechanische Halteeinrichtung, innerhalb der Kammer (1) angeordnet, die das Substrat (6) hält und ihm die Freiheit zur Bewegung in den drei kartesischen Richtungen, x', y', z', sowie zur Rotation um eine Achse, die senkrecht zu seiner Oberfläche ist, θ', und um eine Achse, die parallel zu seiner Oberfläche ist, (ϕ', gibt,
(f) ein Ausgangsmaterial (5), im optischen Pfad der durch das Substrat (6) hindurch übertragenen Strahlung angeordnet und hinreichend nahe dem Substrat (6) angeordnet, so dass die durch die Strahlung erzeugte Dampfphase auf dem Substrat (6) kondensiert,
(g) eine mechanische Halteeinrichtung, innerhalb der Kammer (1) angeordnet, die das Ausgangsmaterial (5) hält und ihm die Freiheit zur Bewegung in den drei kartesischen Richtungen, x, y, z, sowie zur Rotation um eine Achse, die senkrecht zu seiner Oberfläche ist, θ, gibt, so dass es nicht mit dem Substrat (6) einstückig ist,
(h) eine optisch-mechanische Modulationseinrichtung (7, 10), außerhalb der Kammer (1) angeordnet, die die räumliche Verteilung der Lichtstrahlung, die auf das Substrat (6) trifft, entsprechend dem erforderlichen Beugungsmuster moduliert.

12. Vorrichtung zur Herstellung optischer Beugeelemente nach Anspruch 11, **gekennzeichnet dadurch, dass** sie ein System zum Einspeisen von Gasen aufweist.

13. Vorrichtung zur Herstellung optischer Beugeelemente nach Anspruch 11, **gekennzeichnet dadurch, dass** sie eine Wärmequelle für das Ausgangsmaterial (5) aufweist.

14. Vorrichtung zur Herstellung optischer Beugeelemente nach Anspruch 11, **gekennzeichnet dadurch, dass** sie eine Wärmequelle für das Substrat (6) aufweist.

15. Vorrichtung zur Herstellung optischer Beugeelemente nach einem der Ansprüche 11 bis 14, **gekennzeichnet dadurch, dass** sie zusätzliche Lichtstrahlungsquellen zum Herbeiführen des Ausstoßes des Ausgangsmaterials (5) aufweist.

16. Vorrichtung zur Herstellung optischer Beugeelemente nach einem der Ansprüche 11 bis 14, **gekennzeichnet dadurch, dass** sie zusätzliche Lichtstrahlungsquellen zum Aufzeichnen von Beugungsstrukturen aufweist.

17. Vorrichtung zur Herstellung optischer Beugeelemente nach einem der Ansprüche 15 oder 16, **gekennzeichnet dadurch, dass** die im Prozess vorhandenen Lichtstrahlungen einander bezüglich ihrer Kohärenz, Chromatizität und Zeitregime (pulsierend oder kontinuierlich) gleichen.

18. Vorrichtung zur Herstellung optischer Beugeelemente nach einem der Ansprüche 15 oder 16, **gekennzeichnet dadurch, dass** sich die im Prozess vorhandenen Lichtstrahlungen bezüglich ihrer Ausbreitungsrichtung, Intensität, Kohärenz, Chromatizität und Zeitregime (pulsierend oder kontinuierlich) unterscheiden.

## Revendications

1. Procédé pour fabriquer des éléments optiques diffringents, **caractérisé en ce qu'**il comprend les étapes opérationnelles suivantes:
(a) placer un substrat (6), qui est transparent à la fois au rayonnement de travail pour lequel l'élément optique en cours de fabrication est conçu et au rayonnement utilisé dans le processus de fabrication, près d'un matériau de départ (5), tous deux étant situés à l'intérieur d'une chambre (1),
(b) moduler spatialement un rayonnement provenant d'au moins une source de rayonnement lumineux (4) suivant un motif de diffraction requis,
(c) irradier le substrat (6) de telle sorte que le rayonnement le traverse,
(d) exposer le matériau de départ (5) au rayonnement transmis à travers le substrat (6), de telle sorte que lorsque le rayonnement tombe sur le matériau de départ (5), son évaporation ou sa sublimation se produit,
(e) déposer la phase vapeur du matériau de départ (5) sur le substrat (6),
(f) enregistrer une structure diffringente sur le matériau déposé pendant le processus de dépôt, en irradiant simultanément le matériau déposé à travers le substrat (6) avec le rayonnement modulé.

2. Procédé pour fabriquer des éléments optiques diffringents selon la revendication 1, **caractérisé en ce que** les rayonnements lumineux impliqués dans le processus sont continus ou pulsés.

3. Procédé pour fabriquer des éléments optiques diffringents selon les revendications 1 à 2, **caractérisé en ce que** les rayonnements lumineux impliqués dans le processus sont monochromatiques ou polychromatiques.

4. Procédé pour fabriquer des éléments optiques diffringents selon les revendications 1 à 3, **caractérisé en ce que** les rayonnements lumineux impliqués dans le processus sont cohérents ou incohérents.

5. Procédé pour fabriquer des éléments optiques diffringents selon les revendications 1 à 4, **caractérisé en ce que** le matériau de départ (5) est un lingot ou une plaquette fabriqué à partir de la poudre pressée du matériau à déposer.

6. Procédé pour fabriquer des éléments optiques diffringents selon les revendications 1 à 5, **caractérisé en ce que** le matériau de départ (5) peut être un mélange homogène ou hétérogène d'alliages semi-conducteurs contenant un élément chalcogène (O, S, Se et/ou Te) et d'autres réactifs, qui agissent comme des éléments à la fois actifs et passifs pour un rayonnement lumineux déterminé.

7. Procédé pour fabriquer des éléments optiques diffringents selon les revendications 1 à 6, **caractérisé en ce que** le processus est exécuté avec une pression et une atmosphère commandées.

8. Procédé pour fabriquer des éléments optiques diffringents selon les revendications 1 à 7, **caractérisé en ce que** la phase vapeur ou plasma présente dans le processus résulte de l'évaporation et/ou la sublimation du matériau de départ (5) au moyen de l'action conjointe d'un chauffage et d'un rayonnement lumineux.

9. Procédé pour fabriquer des éléments optiques diffringents selon les revendications 1 à 8, **caractérisé en ce que** la température du substrat (6) est différente de la température ambiante.

10. Procédé pour fabriquer des éléments optiques diffringents selon l'une quelconque des revendications 1 à 9, **caractérisé en ce que** les côtés du matériau de départ (5) et du substrat (6) qui sont dirigés l'un vers l'autre sont parallèles.

11. Appareil pour fabriquer des éléments optiques diffringents, lequel comprend:
(a) une chambre (1) avec au moins une fenêtre transparente,
(b) un système sous vide,
(c) une source de rayonnement lumineux,
(d) un substrat (6) qui est transparent à la fois au rayonnement de travail pour lequel l'élément optique à fabriquer est conçu et au rayonnement provenant de la source de rayonnement lumineux, ledit substrat (6) étant situé dans le trajet optique du rayonnement provenant de la source de rayonnement lumineux,
(e) des moyens mécaniques de support, situés à l'intérieur de la chambre (1), lesquels supportent le substrat (6) et lui donnent la liberté de se déplacer dans les trois directions cartésiennes, x', y', z', ainsi que de tourner autour d'un axe qui est perpendiculaire à sa surface, θ', et autour d'un axe qui est parallèle à sa surface, ϕ',
(f) un matériau de départ (5), situé dans le trajet optique du rayonnement transmis à travers le substrat (6) et situé suffisamment près du substrat (6) pour que la phase vapeur générée par l'irradiation se condense sur le substrat (6),
(g) des moyens mécaniques de support, situés à l'intérieur de la chambre (1), lesquels supportent le matériau de départ (5) et lui donnent la liberté de se déplacer dans les trois directions cartésiennes, x, y, z, ainsi que de tourner autour d'un axe qui est perpendiculaire sa surface, θ, de telle sorte qu'il n'est pas solidaire du substrat (6),
(h) des moyens opto-mécaniques de modulation (7, 10), situés à l'extérieur de la chambre (1), lesquels modulent la répartition spatiale du rayonnement lumineux qui tombe sur le substrat (6) suivant le motif de diffraction requis.

12. Appareil pour fabriquer des éléments optiques diffringents selon la revendication 11, **caractérisé en ce qu'**il a un système pour injecter des gaz.

13. Appareil pour fabriquer des éléments optiques diffringents selon la revendication 11, **caractérisé en ce qu'**il a une source de chaleur pour le matériau de départ (5).

14. Appareil pour fabriquer des éléments optiques diffringents selon la revendication 11, **caractérisé en ce qu'**il a une source de chaleur pour le substrat (6).

15. Appareil pour fabriquer des éléments optiques diffringents selon les revendications 11 à 14, **caractérisé en ce qu'**il a des sources supplémentaires de rayonnement lumineux pour provoquer l'éjection du matériau de départ (5).

16. Appareil pour fabriquer des éléments optiques diffringents selon les revendications 11 à 14, **caractérisé en ce qu'**il a des sources supplémentaires de rayonnement lumineux pour enregistrer des structures diffringentes.

17. Appareil pour fabriquer des éléments optiques diffringents selon les revendications 15 ou 16, **caractérisé en ce que** les rayonnements lumineux présents dans le processus sont identiques en termes de cohérence, de chromaticité et de régime temporel (pulsé ou continu).

18. Appareil pour fabriquer des éléments optiques diffringents selon les revendications 15 ou 16, **caractérisé en ce que** les rayonnements lumineux présents dans le processus sont différents en termes de direction de propagation, d'intensité, de cohérence, de chromaticité et de régime temporel (pulsé ou continu).
